# EUROPEAN PATENT SPECIFICATION

(11) **EP 4 530 241 B1**
(45) Date of publication and mention of the grant of the patent: **18.11.2026**
(21) Application number: 24195350.4
(22) Date of filing: 20.08.2024
(51) Int. Cl.: B66B 5/00, G01S 17/89

(54) **METHOD AND APPARATUS FOR DETECTING AND ASSESING ELEVATOR SHAFT OR ELEVATOR MACHINE ROOM USING LIDAR SENSOR**
VERFAHREN UND VORRICHTUNG ZUR ERKENNUNG UND BEURTEILUNG EINES AUFZUGSSCHACHTS ODER AUFZUGSMASCHINENRAUMS UNTER VERWENDUNG EINES LIDAR-SENSORS
PROCÉDÉ ET APPAREIL DE DÉTECTION ET D'ÉVALUATION DE CAGE D'ASCENSEUR OU DE SALLE DE MACHINES D'ASCENSEUR À L'AIDE D'UN CAPTEUR LIDAR

(30) Priority: 01.09.2023 FI 20235976
(43) Date of publication of application: 02.04.2025
(73) Proprietor: Skanio Oy, 20300 Turku (FI)
(72) Inventor: Pilone, Alessandro, 20300 Turku (FI)
(74) Representative: Moosedog Oy

(56) References cited:
- EP-A1- 4 095 036
- US-A1- 2021 116 941

## Description

### TECHNICAL FIELD

The disclosure is related to a method and apparatus of acquiring a digital representation of an elevator in order to perform digital condition assessment surveys. In particular, the disclosure is related to automatically detecting equipment, environment dimensions and possible damaged components in the need of replacement (modernisation) by means of an apparatus and a method for detecting and assessing an elevator shaft or elevator machine room.

### BACKGROUND

Assessment and modernisation of an elevator equipment requires a trained human being entering dangerous spaces eg. elevator shaft or machine room and performing a set of tasks in order to detect and register possible components damages and/or main characteristics eg. dimensions. These tasks are important in order to correctly address needs of replacement (modernisation) and at same time dangerous and prone to human error if not carried out with close monitoring. Known measure to be taken to mitigate threats and risks, include regular safety audits of the personnel, reactive and slow components assessment and manual dimensions recording.

Therefore, in light of the foregoing discussion, there exists a need to overcome the aforementioned drawbacks.

EP 4 095 036 A1 and US 2021/116941 A1 show an apparatus and a method according to the preambles of claims 1 and 4, respectively.

### SUMMARY

This summary is provided to introduce a selection of concepts in a simplified form that are further described below in the detailed description. This brief description is not intended to identify key or essential features of the claim subject matter, nor it is intended to be used to limit the scope of the claimed subject matter.

It is the objective of this brief description to present a method and an arrangement (or apparatus, used interchangeably, hereafter) for providing a detection and assessment of an elevator components main characteristics, status and dimension, and main elevator shaft dimensions in order to perform safe and remote digital condition assessment surveys. A further objective is that the same method and arrangement (or apparatus) would be applicable in different kind of elevator configurations and not excluding escalator and other building technical components or areas.

The aim of the present disclosure is to provide an apparatus and method to solve the technical problem of how to detect and assess elevator components in a safe and reliable manner. The aim of the disclosure is achieved by an apparatus and method for detecting and assessing an elevator shaft or elevator machine room as defined in the appended independent claims to which reference is made to. Advantageous features are set out in the appended dependent claims.

An apparatus for detecting and assessing an elevator shaft, namely, an elevator components and shaft dimensions, in machine room less configuration, or elevator machine room or machine room configuration, comprises a Light Detection and Ranging (LIDAR) sensor configured to generate measurement data, namely, a set of point-cloud data, and an image capturing device configured to generate images. The apparatus comprises the controller besides a Point-Cloud data generation unit, namely, the LIDAR sensor, configured to collect sets of said measurement data, namely, the set of point-cloud data, and an Image generation unit, namely, image capturing device, configured to generate sets of high-resolution images, wherein the controller is configured to merge the point-cloud data and the set of images, and wherein the controller is further configured to generate a set of measurement data, based on the merged point-cloud data and set of images in a given time and transmit said set of measurement data toward a recipient, wherein the apparatus further comprises a support configured to provide a stable and repeatable data measurement location, and wherein the support comprises an extension, a Geography (GEO) and Position device configured to provide a set of coordinates to define a spatial position of the apparatus. The apparatus may further comprise an external 3D CAD system configured to provide a set of Building Information Modelling BIM and 2D layouts for generating a layered 3D virtual model. The apparatus further comprises a support and/or extension configured to provide a stable and repeatable data measurement location. The support is a tripod having an extension. Optionally, the support is a movable support and is configured to attach thereto the Light Detection and Ranging (LIDAR) sensor and the image capturing device.

A method for detecting and assessing an elevator components and shaft dimensions in machine room less configuration or machine room configuration comprises of using Light Detection and Ranging (LIDAR) to generate a set of point-cloud data representing the 3D topography of the elevator shaft and its components. Using an image capturing device to capture a set of images, such as high-resolution images, of the elevator shaft or the elevator machine room; merging the set of point-cloud data and the set of images, and generate a set of measurement data, based on the merged point-cloud data and set of images, in a given time; generating a layered 3D virtual model; using Geography (GEO) and Position device for detecting GEO location position by generating a set of coordinates to define a spatial position of the apparatus; and transmitting said merged point-cloud data and set of images, said set of measurement data, and the set of coordinates from GEO and position device to the recipient, wherein the method is performed using an apparatus that further comprises a support configured to provide a stable and repeatable data measurement location, and wherein the support comprises an extension. Optionally, the method further comprises detecting a difference between two sets of measurement data, namely, point-cloud data, and images taken at different times or time stamp; and generating an indication of said detected differences in the 3D virtual model and transmitting it to a web interface or application accessed by the user.

Many of the claim features will be better understood by reference to the following detailed description considered in connection with the accompanying drawings.

Throughout the description and claims of this specification, the words "comprise", "include", "have", and "contain" and variations of these words, for example "comprising" and "comprises", mean "including but not limited to", and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF DRAWINGS

The accompanying figures (drawings), which are included to provide a further understanding of the invention and constitute part of the specification, illustrate methods and parts of the invention and together with the description are helping to explain the principle of the invention. In the Figures (drawings):
Figure 1 illustrates a traditional Machine Room Less elevator shaft configuration,
Figure 2 illustrates a traditional Machine Room "positions" in an elevator shaft configuration,
Figure 3 illustrates an apparatus location in a traditional Machine Room or Machine Room Less elevator shaft configuration,
Figure 4 illustrates an apparatus location and data acquisition area in a traditional Machine Room or Machine Room Less elevator shaft configuration,
Figure 5 illustrates an apparatus with a LIDAR sensor together with processing and control system, and
Figure 6 illustrates the method, the applications, and interfaces.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In a first aspect, the present disclosure provides an apparatus for detecting and assessing an elevator shaft or elevator machine room, the apparatus comprising:
a Light Detection and Ranging (LIDAR) sensor attached to a movable support and configured to generate a set of point-cloud data representing a 3D topography of the elevator shaft or the elevator machine room;
an image capturing device attached to the movable support and configured to capture a set of images of the elevator shaft or the elevator machine room;
a controller configured to merge the point-cloud data and the set of images, wherein the controller is further configured to generate a set of measurement data, based on the merged point-cloud data and set of images, in a given time and transmit said data to a recipient; and
   a Geography (GEO) and Position device configured to provide a set of coordinates to define a spatial position of the apparatus,
   wherein said controller is communicably coupled to the LIDAR sensor, the image capturing device, and the GEO and Position device, and configured to transmit said merged point-cloud data and set of images and the set of coordinates from GEO and position device to the recipient,
   wherein the apparatus further comprises a support configured to provide a stable and repeatable data measurement location, and wherein the support comprises an extension.

In a second aspect, the present disclosure provides a method for detecting and assessing an elevator shaft or elevator machine room, the method comprising:
using a Light Detection and Ranging (LIDAR) sensor, attached to a movable support, to generate a set of point-cloud data representing a 3D topography of the elevator shaft or elevator machine room;
using an image capturing device, attached to the movable support, to capture a set of images of the elevator shaft or the elevator machine room;
merging the set of point-cloud data and the set of images;
generating a set of measurement data, based on the merged point-cloud data and set of images, in a given time;
generating a layered 3D virtual model;
using a Geography (GEO) and Position device for detecting GEO location position by generating a set of coordinates to define a spatial position of the apparatus; and
transmitting said merged point-cloud data and set of images, said set of measurement data, and the set of coordinates from GEO and position device to the recipient,
wherein the method is performed using an apparatus that further comprises a support configured to provide a stable and repeatable data measurement location, and wherein the support comprises an extension.

The disclosure enables automatically detecting equipment, environment dimensions and possible damaged components in the need of replacement (modernisation). The disclosure aims to provide the aforementioned apparatus and the aforementioned method drastically reduce all risks related to human being entering dangerous spaces eg. elevator shaft or machine room and interacting with elevator components in order to perform an assessment survey. In addition, the disclosure aims to remove completely the human error factor in performing a shaft and equipment dimensions or component/equipment a detailed condition assessment.

According to a first aspect, an apparatus for detecting and assessing an elevator shaft or elevator machine room is provided. The apparatus comprises a Light Detection and Ranging (LIDAR) sensor attached to a movable support and configured to generate a set of point-cloud data (or point cloud data) representing a 3D topography of the elevator shaft or the elevator machine room.

The generated point-cloud data (with LIDAR sensor) has typically a voxel resolution of about 2-10 cm, (i.e., distance between voxels of the point-cloud represented by the point-cloud data). Movable support is useful as it enables to attach apparatus where needed. Beneficially, the generated set of point-cloud data accurately represents the 3D topography of the elevator shaft or the elevator machine room. It may be appreciated that generating a 3D topography of the elevator shaft or the elevator machine room typically involves visualizing the internal structure, components, and layout of the elevator shaft and machine room (cabin). Optionally, such 3D topography includes details like the positioning of the elevator cables or internal components (such as the pulley system, cabin, counterweight, etc.), and mechanical systems.

An image capturing device attached to the movable support and configured to capture a set of images of the elevator shaft or the elevator machine room. Unlike the LIDAR sensor, the image capturing device, such as a high-resolution camera, can be used to take detailed (high resolution) images with a resolution that enables detection of details less than millimetre of at least some parts of the elevator shaft or the elevator machine room, depending on the distance between the camera and the at least some of the parts. Examples of high-resolution cameras can be a 1Mega pixel (Mpixel), 10Mpixel camera, or the like. The high-resolution device has typically related camera optics. Image capturing devices generate 2D images. Images are preferably high-resolution images.

The apparatus also comprises a Geography (GEO) and Position device configured to provide a set of coordinates to define a spatial position of the apparatus. Optionally, the Geography (GEO) and Position device is for example GPS (Global Positioning System) devices, geographic information systems (GIS), or even specific sensors and tools used in geolocation. Beneficially, the ability to determine the spatial position of the apparatus using GEO and Position devices brings significant benefits in terms of efficiency, safety, environmental sustainability, and technological advancement. For example, accurate positioning enables quicker response times in emergencies. First responders or operators of such apparatus or the elevator can be directed to the exact location of an incident, such as the elevator shaft or the elevator machine room, or the floor where the lift is currently stopped. Moreover, tracking the position of the apparatus in real-time, improves the ability to prevent risks associated with life, or unauthorized access to the elevator and potential misuse thereof or theft therein.

The apparatus comprises also a controller configured to merge the point-cloud data and the set of images, wherein the controller is further configured to generate a set of measurement data, based on the merged point-cloud data and set of images, in a given time and transmit said data to a recipient. Technical benefit of merging the point-cloud data (3D data) with the set of images (2D data) is to make an overall representation which has both details from high-resolution images as well as depth information from the LIDAR sensor-captured point-cloud data. This way 3D structures of elevator shaft and components can be captured in an efficient and accurate manner. The set of measurement data may comprise additional information, such as an indication of the reflectivity of the surface from which the laser pulse (or group of laser pulses) is reflected or a high-resolution image capturing visual condition and status of the overall elevator components, fixings and elevator shaft condition. Moreover, the controller is communicably coupled to the LIDAR sensor, the image capturing device, and the GEO and Position device, and configured to transmit said merged point-cloud data and set of images and the set of coordinates from GEO and position device to the recipient. Herein, the recipient is a web interface or application. The web interface or application that uses spatial data refers to a digital platform accessible through a web browser that interacts with and visualizes geographic or spatial data. This type of application enables web interface or application users to view, analyze, manipulate, and interact with data related to specific locations of the apparatus.

The apparatus may further comprise an external 3D CAD system configured to provide a set of Building Information Modelling BIM and 2D layouts for generating a layered 3D virtual model.

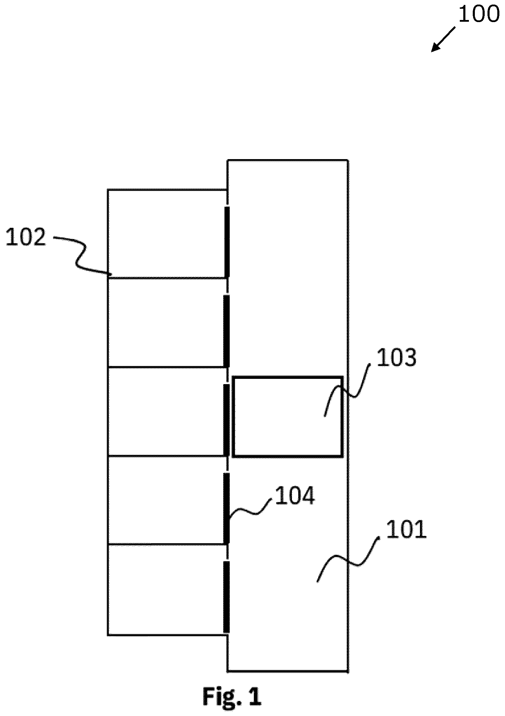

Figure 1 illustrates a traditional Machine Room Less elevator shaft configuration 100 which includes a car or cabin 103 intendent to carry passengers in correlation with the admitted maximum load, a landing door 104 enclosing the elevator shaft 101 from external access of not authorized personnel, and landing floor areas 102 utilized as a lobby area when waiting. In this exemplary implementation, the Machine Room Less elevator shaft 101 may be for example made in concrete or steel structure and the amount and configuration of served floors does not alter nor reduce the invention application.

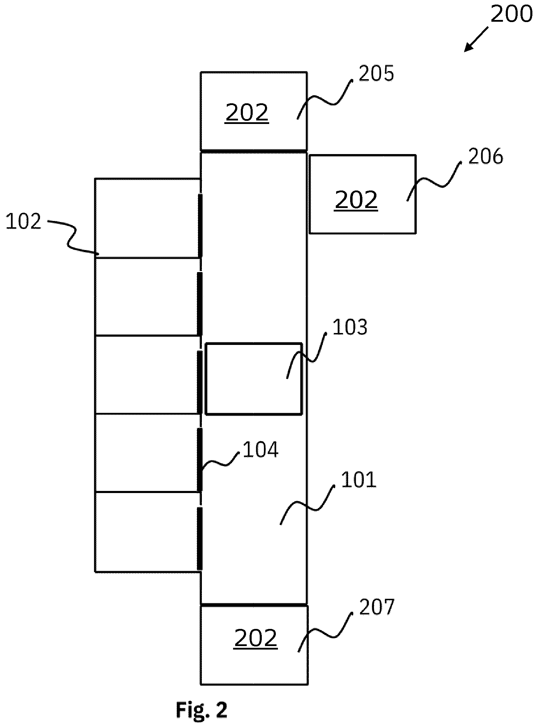

Figure 2 illustrates another example of Machine Room elevator shaft configuration 200 including a machine room 202 which can be located above 205, beside 206 and below 207 the elevator shaft 101. The machine room 202 is the area where main elevator components are situated.

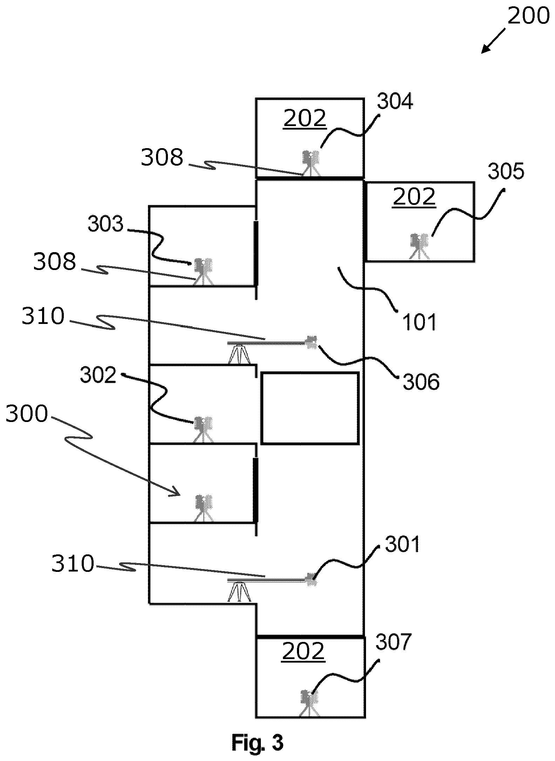

Figure 3 illustrates a detailed positioning of an apparatus 300, comprising a Light detector and ranging (LIDAR) sensor 301, 302, 303 304, 305, 306, 307 in a Machine Room elevator shaft configuration 200. Survey method begins by using an extended LIDAR sensor 301 positioning, attached to a telescopic support or other type of extensions means, such as a movable support 310, in order to acquire the lower part of the elevator shaft 101 also called pit, providing a safe working environment removing the need for an operator to enter the elevator shaft 101 and operate safety measures in case of failure. A Geography (GEO) and position device (not shown) defines the LIDAR sensor 301 correct set up and a repeatability of the survey.

Following the Machine Room elevator shaft 101, the LIDAR sensor 302 is positioned on the floor in front of the car (cabin) in order to acquire the car (cabin) interior construction and visual elements. While moving upwards, the LIDAR sensor 303 is positioned on the floor in front of the landing door in order to acquire the entire floor and door opening dimensions, the LIDAR sensor 303 positioning is repeated at each floor which is dependent of the elevator shaft configuration 101.

In order to complete the survey of the Machine Room elevator shaft 101, the extended LIDAR sensor 306, attached to a telescopic support or other type of extensions means, such as a movable support 310, provides capabilities to acquire data from top of the Machine Room elevator shaft 101 and a safe environment removing the need to enter the elevator shaft 101 and operate safety measures in case of failure. A repeated LIDAR sensor 304, 305, 307 positioning is used also for acquiring data in machine room 202 above205, beside 206 and below 207 the elevator shaft 101 which is applicable in Machine Room elevator shaft configuration 200 only.

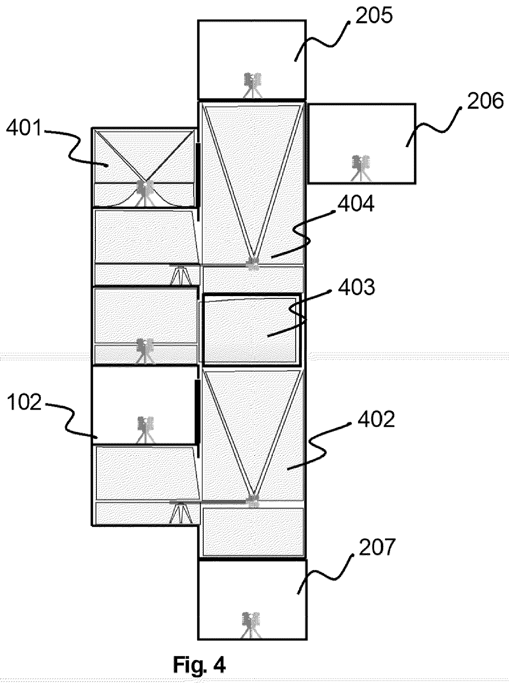

Figure 4 illustrates the LIDAR sensors 301, 302, 303 304, 305, 306, 307 data coverage for each of the positioning expressed in figure 3, as is known for LIDAR sensors 301, 302, 303 304, 305, 306, 307, the measurement data represents primarily distance measurement, so that each individual piece of measurement data is an indication of a distance between the current position of the LIDAR sensor 301, 302, 303 304, 305, 306, 307 and the surface (in areas 401, 402, 403, 405) from which a particular laser pulse (or group of laser pulses) is reflected. The set of measurement data may comprise additional information, such as an indication of the reflectivity of the surface from which the laser pulse (or group of laser pulses) is reflected or a high-resolution image capturing visual condition and status of the overall elevator components, fixings and elevator shaft 101 condition.

Utilising LIDAR sensors 310 and 306 positioning, the data acquired will result in the entire elevator shaft virtual representation including the so called "pit" and "headroom" 402 & (and) 404, respectively. Utilising LIDAR sensor 302 positioning, the data acquired will result in the virtual representation of the entire car or "cabin" internal structure, car or "cabin" material, the design, and the floor space in front 403. Utilising LIDAR sensor 303 positioning, the data acquired will result in the virtual representation of the floor and elevator landing door and the actual set up would be repeated on each floor following the actual elevator shaft configuration. Utilising LIDAR sensor 304, 305 and 307 positioning, the data acquired will result in the machine room 205, 206 and 207 walls, wall material, structure, and elevator components virtual representation, respectively.

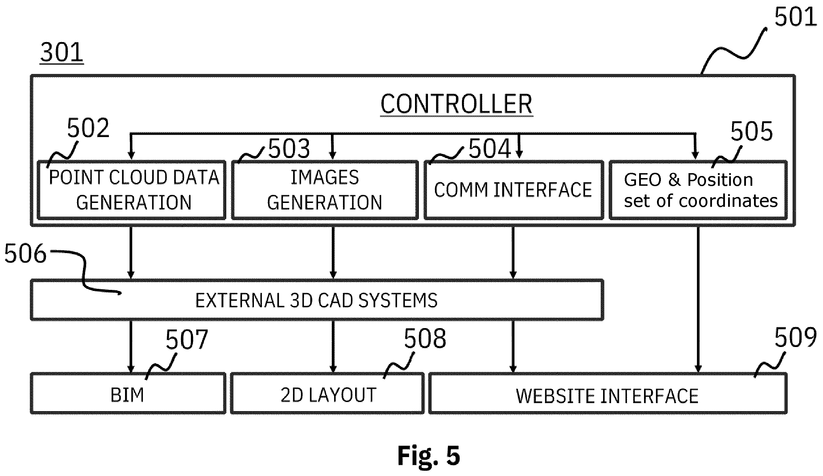

Figure 5 illustrates an example of a block diagram of an apparatus comprising a LIDAR sensor, such as a LIDAR sensor 502, an image capturing device 503, a controller 501, a GEO and Position device 505. The controller 501 is communicably coupled to a point-cloud generation device, namely the LIDAR sensor 502. The LIDAR sensor 502 comprises a transmission and receiver that performs actual transmission and reception of the laser pulses. The transmission and receiver utilise a sort of spin action to transmit and receive close to 360-degree laser pulses in order to create a 3D digital cloud of points so called point-cloud data. The transmission and receiver may also contain a plurality of transmitter and receiver in order to increase data density and measurement accuracy.

The controller 501 is communicably coupled to an image generation device, namely the image capturing device 503, such as a high-resolution camera or cameras, producing high resolution images which are then merged with the point-cloud data generated by the LIDAR sensor 502 communicably coupled to the controller 501. The controller 501 is communicably coupled to a Geography (GEO) & Position device 505 to achieve a measurement repeatability producing a set of coordinates to define a spatial position of the apparatus. The controller 501 is communicably coupled to a communication interface 504 for data transferring and live measurement status and quality. The communication interface 504 could be working either by wire or wireless type of protocol transmissions.

When all measurements following Figure 4 are completed, the controller 501 may merge and send all point-cloud data, set of images and GEO and Position set of coordinates to an external 3D CAD (computer aided design) system 506 or external 3D CAD type of application in a form of a single project file, via the communication interface. Utilising the external 3D CAD system 506 computing power, a final product in a form of Building Information Modelling 507, 2D Layout 508 and website interface 509 could be exported and or published. The overall measurement process of Figure 4 together with the block diagram of Figure 5 could be repeated in a series of multiple measurements in a defined time frame in order to make the point-cloud data, the set of images and the Geo & Position set of coordinates useful for data comparison for a detection of elevator shaft configuration of Figure 1 unexpected changes or elevator components structural damages, status and the overall elevator safety.

Optionally, said controller is configured to transmit said set of point-cloud data, said set of high-resolution images, said set of coordinates from GEO and position to a web interface or application. In this regard, the web interface or application is configured to generate a digital twin of the elevator shaft or the elevator machine room for a virtual representation of the operations of the elevator, in real-time.

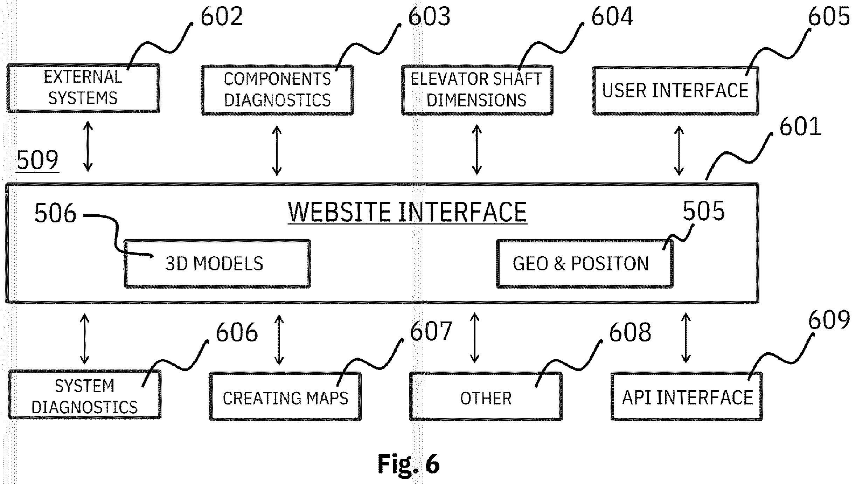

Figure 6 illustrates a block diagram of a Website Interface 509. The entire Website interface control 601 comprise of a 3D CAD Model 506 where the point-cloud data are layered in order to follow the detailed LIDAR sensor positioning in Figure 3 and a GEO and Position device which determines the exact position coordinates, namely, set of coordinates 505, which could be included in an interactive map. The Website Interface control 601 produces several modules offering various services and data utilisation. The external system interface module 602 together with the API interface module 609 provide a wide range of connectivity interfaces in order to make the data and functions available to a third-party system and/or application to use. A Components diagnostic module 603 together with a system diagnostic module 606 comprise of all necessary data measurements and images taken with time intervals in order to automatically detect changes by comparing at least two sets of point-of cloud data and images from two different time stamps provided by the controller 501. Additionally, the component diagnostic module 603 has a function of recognizing different elevator main components after each LIDAR sensor measurement providing an accurate description, dimension accuracy and main characteristic. The elevator shaft dimension module 604 comprises a set of LIDAR sensor measurement point-cloud data representing the elevator shaft overall dimensions (high, width, depth, door openings and other construction elements). Integrating the controller 501 data together with: the 3D CAD models 506, the components diagnostic module 603 and the elevator shaft dimensions module 604 and meshed in a digital representation so called layered 3D virtual model 506 (so called "digital twin") of the elevator unit and its component can be represented in the website interface 601. Several additional features such as a user interface module 605 which would enable advanced interaction with the digital twin representation; the creating map module 607 provides GEO coordinates of the unit and which could be utilised in a third-party map services to visually localise the elevator shaft and its components.

The basic idea of the invention may be implemented in various ways. The invention and its embodiments are thus not limited to the example described above; instead, they may vary within the scope of the claim.

As an example, LIDAR measurement and methodologies could be used in an escalator or other building technical systems.

According to one aspect, an apparatus for detecting and assessing an elevator components and shaft dimensions in machine room less configuration or machine room configuration comprises a LIDAR sensor configured to generate measurement data, namely, the point-cloud data, and images. A Point-Cloud data generation module, namely, the LIDAR sensor, is configured to collect sets of said measurements or point-cloud data and an Image generation, namely, the image capturing device, configured to generate sets of high-resolution images. A movable support and/or extension configured to provide a stable and repeatable data measurement and location.

The present disclosure also relates to the method as described above. Various embodiments and variants disclosed above, with respect to the aforementioned apparatus, apply mutatis mutandis to the method.

According to a second aspect a method for detecting and assessing an elevator components and shaft dimensions in machine room less configuration or machine room configuration, comprises of using LIDAR to generate a set of point cloud data representing the 3D topography of the elevator shaft and its components. Detecting a difference between two sets of data measurement and images taken at different time stamp.

Optionally, the method comprises:
detecting a difference between two sets of point-cloud data (502) and high-resolution images (503) taken at different times; and
generating an indication of said detected differences in the 3D virtual model (506) and transmitting it to the recipient.

In this regard, the two sets of point-cloud data (502) and high-resolution images (503) taken at different times may be on the same floor or different floors. Beneficially, the detected differences may be used to correct a potential defect associated with operations of the elevator shaft or the elevator machine room.

Optionally, the recipient is a web interface (601) or application.

Optionally, a user interface module (605) is configured to allow web interface (601) or application users to interact with the set of 3D virtual model (506) for performing a pre-set type of actions. Optionally, the pre-set actions include, but do not limit to, visualizing the 3D topography of the elevator shaft or elevator machine room, switching between a "working" and a "resting" mode of the elevator.

Optionally, the merged set of point-cloud data and images are compared with a digital library containing pre-stored data related at least to the elevator shaft or the elevator machine room. Herein, the term *"digital library"* refers to a database storing data corresponding to the apparatus and functioning thereof. It may be appreciated that the digital library may store data corresponding to malfunctions in the apparatus at different time points/stamps along with the time stamps corresponding to the apparatus malfunction. Beneficially, said comparison indicated the frequency and nature of malfunctions of the elevator or errors in the elevator shaft or elevator machine room.

Optionally, the merged set of point-cloud data and images are compared with a set of pre-stored point-cloud data and images to detect differences between the merged set of point-cloud data and images and the set of pre-stored point-cloud data and images. Beneficially, said comparison indicated the frequency and nature of malfunctions of the elevator or errors in the elevator shaft or elevator machine room.

Optionally, an indication is generated if the differences are above a predetermined limit. Optionally, the indication is generated as a voice feedback/alarm, a visual feedback/alarm, a haptic feedback/alarm, or any combination thereof. For example, the visual feedback/alarm may be identified as a "green light" indicative of correct functioning of the elevator shaft or elevator machine room, a "red light" indicative of incorrect functioning of the elevator shaft or elevator machine room, and so on.

## Claims

1. An apparatus (300) for detecting and assessing an elevator shaft (101) or elevator machine room (202), the apparatus comprising:
a Light Detection and Ranging (LIDAR) sensor (301, 302, 303, 304, 305, 306, 307, 502) attached to a movable support (308, 310) and configured to generate a set of point-cloud data representing a 3D topography of the elevator shaft or the elevator machine room;
an image capturing device (503) attached to the movable support and configured to capture a set of images of the elevator shaft or the elevator machine room;
a controller (501) configured to merge the point-cloud data and the set of images, wherein the controller (501) is further configured to generate a set of measurement data, based on the merged point-cloud data and set of images, in a given time and transmit said set of measurement data to a recipient; and
a Geography (GEO) and Position device (505) configured to provide a set of coordinates to define a spatial position of the apparatus,
wherein said controller is communicably coupled to the LIDAR sensor, the image capturing device, and the GEO and Position device, and configured to transmit said merged point-cloud data and set of images and the set of coordinates from GEO and position device to the recipient,
**characterised in that** the apparatus further comprises a support configured to provide a stable and repeatable data measurement location, and wherein the support is a tripod having an extension.

2. An apparatus according to claim 1, wherein the recipient is a web interface (601) or application.

3. An apparatus according to claim 1 or 2, further comprising an external 3D CAD system (506) configured to provide a set of Building Information Modelling BIM (507) and 2D layouts (508) for generating a layered 3D virtual model.

4. A method for detecting and assessing an elevator shaft (101)_or elevator machine room (202), the method comprising:
using a Light Detection and Ranging (LIDAR) sensor (301, 302, 303, 304, 305, 306, 307, 502), attached to a movable support (308, 310), to generate a set of point-cloud data representing a 3D topography of the elevator shaft or elevator machine room;
using an image capturing device (503), attached to the movable support, to capture a set of images of the elevator shaft or the elevator machine room;
merging the set of point-cloud data and the set of images;
generating a set of measurement data, based on the merged point-cloud data and set of images, in a given time;
generating a layered 3D virtual model (506);
using a geography (GEO) and Position device (505) for detecting GEO location position by generating a set of coordinates to define a spatial position of the apparatus; and
transmitting said merged point-cloud data and set of images, said set of measurement data, and the set of coordinates from GEO and position device to the recipient,
**characterised in** the the method is performed using an apparatus that further comprises a support configured to provide a stable and repeatable data measurement location, and wherein the support is a tripod having an extension.

5. A method according to claim 4, comprising:
detecting a difference between two sets of point-cloud data and high-resolution images taken at different times; and
generating an indication of said detected differences in the 3D virtual model (506) and transmitting it to the recipient.

6. A method according to claim 4 or 5, wherein the recipient is a web interface (601) or application.

7. A method according to any of the preceding claims 4-6, wherein a user interface module (605) is configured to allow web interface (601) or application users to interact with the layered 3D virtual model (506) for performing a pre-set type of actions.

8. A method according to any of preceding claims 4-7, wherein the merged set of point-cloud data and images are compared with a digital library containing pre-stored data related at least to the elevator shaft (101) or the elevator machine room (202).

9. A method according to any of preceding claims 4-8, wherein the merged set of point-cloud data and images are compared with a set of pre-stored point-cloud data and images to detect differences between the merged set of point-cloud data and images and the set of pre-stored point-cloud data and images.

10. A method according to claim 9, wherein an indication is generated if the differences are above a predetermined limit.

## Patentansprüche

1. Einrichtung (300) zum Erkennen und Beurteilen eines Aufzugsschachts (101) oder Aufzugsmaschinenraums (202), die Einrichtung umfassend:
einen Light Detection and Ranging-Sensor (LIDAR-Sensor) (301, 302, 303, 304, 305, 306, 307, 502), der an einem beweglichen Träger (308, 310) angebracht und konfiguriert ist, um einen Satz von Punktwolkendaten zu erzeugen, der eine 3D-Topographie des Aufzugsschachts oder des Aufzugsmaschinenraums darstellt;
eine Bildaufnahmevorrichtung (503), die am beweglichen Träger angebracht und konfiguriert ist, um einen Satz von Bildern des Aufzugsschachts oder des Aufzugsmaschinenraums aufzunehmen;
eine Steuerung (501), die konfiguriert ist, um die Punktwolkendaten und den Satz von Bildern zusammenzuführen, wobei die Steuerung (501) ferner konfiguriert ist, um einen Satz von Messdaten basierend auf den zusammengeführten Punktwolkendaten und dem Satz von Bildern in einer gegebenen Zeit zu erzeugen und den Satz von Messdaten an einen Empfänger zu übertragen; und
eine Geographie(GEO)- und Positionsvorrichtung (505), die konfiguriert ist, um einen Satz von Koordinaten bereitzustellen, um eine räumliche Position der Einrichtung zu definieren,
wobei die Steuerung kommunikativ an den LIDAR-Sensor, die Bildaufnahmevorrichtung und die GEO- und Positionsvorrichtung gekoppelt und konfiguriert ist, um die zusammengeführten Punktwolkendaten und den Satz von Bildern und den Satz von Koordinaten von der GEO- und Positionsvorrichtung an den Empfänger zu übertragen,
**dadurch gekennzeichnet, dass** die Einrichtung ferner einen Träger umfasst, der konfiguriert ist, um einen stabilen und wiederholbaren Datenmessort bereitzustellen, und wobei der Träger ein Stativ mit einer Verlängerung ist.

2. Einrichtung nach Anspruch 1, wobei der Empfänger eine Webschnittstelle (601) oder -anwendung ist.

3. Einrichtung nach Anspruch 1 oder 2, ferner umfassend ein externes 3D-CAD-System (506), das konfiguriert ist, um einen Satz von Building Information Modelling, BIM, (507) und 2D-Layouts (508) zum Erzeugen eines geschichteten virtuellen 3D-Modells bereitzustellen.

4. Verfahren zum Erkennen und Beurteilen eines Aufzugsschachts (101)_oder Aufzugsmaschinenraums (202), das Verfahren umfassend:
Verwenden eines Light Detection and Ranging-Sensors (LIDAR-Sensors) (301, 302, 303, 304, 305, 306, 307, 502), der an einem beweglichen Träger (308, 310) angebracht ist, um einen Satz von Punktwolkendaten zu erzeugen, der eine 3D-Topographie des Aufzugsschachts oder Aufzugsmaschinenraums darstellt;
Verwenden einer Bildaufnahmevorrichtung (503), die am beweglichen Träger angebracht ist, um einen Satz von Bildern des Aufzugsschachts oder des Aufzugsmaschinenraums aufzunehmen;
Zusammenführen des Satzes von Punktwolkendaten und des Satzes von Bildern;
Erzeugen eines Satzes von Messdaten basierend auf den zusammengeführten Punktwolkendaten und dem Satz von Bildern in einer gegebenen Zeit;
Erzeugen eines geschichteten virtuellen 3D-Modells (506);
Verwenden einer Geografie(GEO)- und Positionsvorrichtung (505) zum Erkennen einer GEO-Ort-Position durch Erzeugen eines Satzes von Koordinaten, um eine räumliche Position der Einrichtung zu definieren; und
Übertragen der zusammengeführten Punktwolkendaten und des Satzes von Bildern, des Satzes von Messdaten und des Satzes von Koordinaten von der GEO- und Positionsvorrichtung an den Empfänger,
**dadurch gekennzeichnet, dass** das Verfahren unter Verwendung einer Einrichtung durchgeführt wird, die ferner einen Träger umfasst, der konfiguriert ist, um einen stabilen und wiederholbaren Datenmessort bereitzustellen, und wobei der Träger ein Stativ mit einer Verlängerung ist.

5. Verfahren nach Anspruch 4, umfassend:
Erkennen eines Unterschieds zwischen zwei Sätzen von Punktwolkendaten und hochauflösenden Bildern, die zu unterschiedlichen Zeiten aufgenommen wurden; und
Erzeugen einer Angabe der erkannten Unterschiede in dem virtuellen 3D-Modell (506) und Übertragen derselben an den Empfänger.

6. Verfahren nach Anspruch 4 oder 5, wobei der Empfänger eine Webschnittstelle (601) oder -anwendung ist.

7. Verfahren nach einem der vorstehenden Ansprüche 4 bis 6, wobei ein Bedienerschnittstellenmodul (605) konfiguriert ist, um Benutzern der Webschnittstelle (601) oder -anwendung zu ermöglichen, mit dem geschichteten virtuellen 3D-Modell (506) zum Durchführen eines voreingestellten Typs von Aktionen zu interagieren.

8. Verfahren nach einem der vorstehenden Ansprüche 4 bis 7, wobei der zusammengeführte Satz von Punktwolkendaten und Bildern mit einer digitalen Bibliothek verglichen wird, die vorgespeicherte Daten, die sich mindestens auf den Aufzugsschacht (101) oder den Aufzugsmaschinenraum (202) beziehen, enthält.

9. Verfahren nach einem der vorstehenden Ansprüche 4 bis 8, wobei der zusammengeführte Satz von Punktwolkendaten und Bildern mit einem Satz von vorgespeicherten Punktwolkendaten und Bildern verglichen wird, um Unterschiede zwischen dem zusammengeführten Satz von Punktwolkendaten und Bildern und dem Satz von vorgespeicherten Punktwolkendaten und Bildern zu erkennen.

10. Verfahren nach Anspruch 9, wobei eine Angabe erzeugt wird, wenn die Unterschiede über einem vorbestimmten Grenzwert liegen.

## Revendications

1. Appareil (300) permettant de détecter et d'évaluer une cage d'ascenseur (101) ou un local technique d'ascenseur (202), l'appareil comprenant :
un capteur de détection et télémétrie par ondes lumineuses (LIDAR) (301, 302, 303, 304, 305, 306, 307, 502) attaché à un support mobile (308, 310) et configuré pour générer un ensemble de données de nuages de points représentant une topographie 3D de la cage d'ascenseur ou du local technique d'ascenseur ;
un dispositif de capture d'image (503) attaché au support mobile et configuré pour capturer un ensemble d'images de la cage d'ascenseur ou du local technique d'ascenseur ;
un dispositif de commande (501) configuré pour fusionner les données de nuages de points et l'ensemble d'images, dans lequel le dispositif de commande (501) est configuré en outre pour générer un ensemble de données de mesure, en fonction des données de nuages de points et de l'ensemble d'images, fusionnés, dans un temps donné et transmettre ledit ensemble de données de mesure à un destinataire ; et
un dispositif de géographie (GEO) et de position (505) configuré pour fournir un ensemble de coordonnées pour définir une position spatiale de l'appareil,
dans lequel ledit dispositif de commande est couplé par communication au capteur LIDAR, au dispositif de capture d'image, et au dispositif GEO et de position, et configuré pour transmettre lesdites données de nuages de points et ledit ensemble d'images, fusionnés, et l'ensemble de coordonnées, du dispositif GEO et de position vers le destinataire,
**caractérisé en ce que** l'appareil comprend en outre un support conçu pour fournir une localisation de mesure de données stable et reproductible, et dans lequel le support est un trépied ayant une extension.

2. Appareil selon la revendication 1, dans lequel le destinataire est une interface web (601) ou une application.

3. Appareil selon la revendication 1 ou 2, comprenant en outre un système de CAO 3D externe (506) configuré pour fournir un ensemble de modélisation d'informations de bâtiment BIM (507) et de plans 2D (508) permettant de générer un modèle virtuel 3D en couches.

4. Procédé permettant de détecter et d'évaluer une cage d'ascenseur (101) ou un local technique d'ascenseur (202), le procédé comprenant :
l'utilisation d'un capteur de détection et télémétrie par ondes lumineuses (LIDAR) (301, 302, 303, 304, 305, 306, 307, 502) attaché à un support mobile (308, 310), pour générer un ensemble de données de nuages de points représentant une topographie 3D de la cage d'ascenseur ou du local technique d'ascenseur ;
l'utilisation d'un dispositif de capture d'image (503) attaché au support mobile, pour capturer un ensemble d'images de la cage d'ascenseur ou du local technique d'ascenseur ;
la fusion de l'ensemble de données de nuages de points et de l'ensemble d'images ;
la génération d'un ensemble de données de mesure, en fonction des données de nuages de points et de l'ensemble d'images, fusionnés, dans un temps donné ;
la génération d'un modèle virtuel 3D en couches (506) ;
l'utilisation d'un dispositif de géographie (GEO) et de position (505) pour la détection de position de localisation GEO en générant un ensemble de coordonnées pour définir une position spatiale de l'appareil ; et
la transmission desdites données de nuages de points et dudit ensemble d'images, fusionnés, dudit ensemble de données de mesure, et de l'ensemble de coordonnées provenant du dispositif GEO et de position vers le destinataire,
**caractérisé en ce que** le procédé est mis en œuvre à l'aide d'un appareil qui comprend en outre un support conçu pour fournir une localisation de mesure de données stable et reproductible, et dans lequel le support est un trépied ayant une extension.

5. Procédé selon la revendication 4, comprenant :
la détection d'une différence entre deux ensembles de données de nuages de points et des images à haute résolution prises à des moments différents ; et
la génération d'une indication desdites différences détectées dans le modèle virtuel 3D (506) et sa transmission au destinataire.

6. Procédé selon la revendication 4 ou 5, dans lequel le destinataire est une interface web (601) ou une application.

7. Procédé selon l'une quelconque des revendications 4 à 6 précédentes, dans lequel un module d'interface utilisateur (605) est configuré pour permettre à des utilisateurs de l'interface web (601) ou de l'application d'interagir avec le modèle virtuel 3D en couches (506) pour la mise en œuvre d'un type d'actions préétabli.

8. Procédé selon l'une quelconque des revendications 4 à 7 précédentes, dans lequel l'ensemble fusionné de données de nuages de points et d'images est comparé à une bibliothèque numérique contenant des données précédemment stockées se rapportant à la cage d'ascenseur (101) ou au local technique d'ascenseur (202).

9. Procédé selon l'une quelconque des revendications 4 à 8 précédentes, dans lequel l'ensemble fusionné de données de nuages de points et d'images est comparé à un ensemble de données de nuages de points et d'images précédemment stocké pour détecter des différences entre l'ensemble fusionné de données de nuages de points et d'images et l'ensemble de données de nuages de points et d'images précédemment stocké.

10. Procédé selon la revendication 9, dans lequel une indication est générée si les différences sont au-dessus d'une limite prédéterminée.
